# EUROPEAN PATENT APPLICATION

(11) **EP 4 366 095 A1**
(43) Date of publication of application: **08.05.2024**
(21) Application number: 22891524.5
(22) Date of filing: 28.07.2022
(51) Int. Cl.: H01R 13/02, H01R 13/648, H01R 12/71

(54) **CONNECTOR, CONNECTOR ASSEMBLY, RADIO FREQUENCY MODULE AND COMMUNICATION DEVICE**

(30) Priority: 10.11.2021 CN 202111329015
(71) Applicant: Huawei Technologies Co., Ltd., Longgang Shenzhen, Guangdong 518129 (CN)
(72) Inventor: XU, Kou, Shenzhen, Guangdong 518129 (CN); LIU, Xuecong, Shenzhen, Guangdong 518129 (CN); LI, Jiangnan, Shenzhen, Guangdong 518129 (CN); DENG, Lianghui, Shenzhen, Guangdong 518129 (CN)
(74) Representative: Thun, Clemens
(86) International application number: PCT/CN2022/108666
(87) International publication number: WO 2023/082715

(57) **Abstract**

This application provides a connector, a connector assembly, a radio frequency module, and a communication device. The connector includes a first spring terminal module, a second spring terminal module, an isolation member, and a golden finger contact end. The golden finger contact end includes a first golden finger module and a second golden finger module. The first spring terminal module includes a plurality of first spring terminals. First ends of the plurality of first spring terminals are soldered to a ground plane of a printed circuit board, and second ends of the plurality of first spring terminals abut against the first golden finger module. The second spring terminal module includes a plurality of second spring terminals. First ends of the plurality of second spring terminals are soldered to the ground plane of the printed circuit board, and second ends of the plurality of second spring terminals abut against the second golden finger module. The isolation member is disposed between the first spring terminal module and the second spring terminal module. According to embodiments of this application, high isolation required for radio frequency transmission on a golden finger contact interface can be implemented, and effect of reducing near-end crosstalk can be achieved.

## Description

### CROSS-REFERENCE TO RELATED APPLICATIONS

This application claims priority to Chinese Patent Application No. 202111329015.9, filed with the Chinese Patent Office on November 10, 2021 and entitled "CONNECTOR, CONNECTOR ASSEMBLY, RADIO FREQUENCY MODULE, AND COMMUNICATION DEVICE", which is incorporated herein by reference in its entirety.

### TECHNICAL FIELD

This application relates to the field of connector technologies, and in particular, to a connector, a connector assembly, a radio frequency module, and a communication device.

### BACKGROUND

A wireless small cell is an important terminal for supporting a wireless communication product in implementing indoor network coverage. A small cell product serves as a last branch of sending a radio frequency signal, and signal coverage and power consumption of the small cell product directly affects a quantity of terminals deployed in an indoor building or an area and electrical energy costs of sustainable operation. Therefore, radio frequency signal coverage and power consumption become important competitiveness indicators of a radio frequency terminal such as a small cell.

Currently, in a conventional common public radio interface (Common Public Radio Interface, CPRI) architecture of the wireless small cell, there is a high-power processing requirement of converting an analog signal into a digital signal in advance in a radio remote unit. This brings great challenges to heat dissipation, power consumption, and power improvement of a product under a constraint of a fixed volume. If digital demodulation can be shifted forward to a remote radio unit hub (Remote Radio Unit HUB, RHUB), a volume, power consumption, and the like of the remote radio unit can be released, so that competitiveness is improved. This is a new radio-over-fiber (Radio-Over-Fiber, ROF) architecture. In an external interface connector solution, an analog signal need to be directly transmitted outside. Therefore, a high-isolation radio frequency connector is required for product implementation. How to design a high-isolation radio frequency connector is an urgent problem to be currently resolved.

### SUMMARY

In view of this, this application provides a connector, a connector assembly, a radio frequency module, and a communication device. According to embodiments of this application, high isolation required for radio frequency transmission on a golden finger contact interface can be implemented, and effect of reducing near-end crosstalk can also be achieved.

According to a first aspect, an embodiment of this application provides a connector. The connector is fastened on a printed circuit board. The connector includes a first spring terminal module, a second spring terminal module, an isolation member, and a golden finger contact end. The golden finger contact end includes a first golden finger module and a second golden finger module. The first spring terminal module includes a plurality of first spring terminals, the plurality of first spring terminals each include a signal transmit terminal, first ends of the plurality of first spring terminals are soldered to a ground plane of the printed circuit board, and second ends of the plurality of first spring terminals abut against the first golden finger module. The second spring terminal module includes a plurality of second spring terminals, the plurality of second spring terminals each include a signal receive terminal, first ends of the plurality of second spring terminals are soldered to the ground plane of the printed circuit board, and second ends of the plurality of second spring terminals abut against the second golden finger module. The isolation member is soldered to the ground plane of the printed circuit board, and the isolation member is disposed between the first spring terminal module and the second spring terminal module, to isolate the first spring terminal module and the second spring terminal module in different chambers.

According to the connector in this embodiment of this application, the isolation member may be soldered to the ground plane of the printed circuit board, to connect the isolation member to the ground plane of the printed circuit board. In addition, the isolation member may further isolate two spring terminal modules in two different chambers. In this way, high isolation required for radio frequency transmission on a golden finger contact interface can be implemented, and effect of reducing near-end crosstalk can also be achieved.

In a possible design, an accommodation groove is disposed at the golden finger contact end, and the accommodation groove is located between the first golden finger module and the second golden finger module; and when the golden finger contact end abuts against the plurality of first spring terminals and the plurality of second spring terminals, at least a part of the isolation member is accommodated in the accommodation groove. Based on such a design, at least a part of the isolation member may be in contact with the golden finger contact end. In this way, the first golden finger module and the second golden finger module can be isolated in two different chambers, so that isolation of the golden finger contact interface is increased.

In a possible design, the isolation member includes a first isolation plate, a first metal dome is disposed on the first isolation plate, and a first metal layer is disposed on an inner wall of the accommodation groove; and when at least the part of the isolation member is accommodated in the accommodation groove, the first metal dome abuts against the first metal layer, to provide grounding for the golden finger contact end. Based on such a design, the first metal dome provides grounding for the golden finger contact end, so that the connector can form an electromagnetic shielding cavity. In this way, high isolation required for radio frequency transmission on the golden finger contact interface can be implemented.

In a possible design, the isolation member includes a second isolation plate, and a second metal dome is disposed on the second isolation plate; and when at least the part of the isolation member is accommodated in the accommodation groove, the second metal dome abuts against the first metal layer, to provide grounding for the golden finger contact end. Based on such a design, the isolation member may provide grounding for the golden finger contact end by using the second metal dome. Based on such a design, the second metal dome can also provide grounding for the golden finger contact end, so that the connector can form an electromagnetic shielding cavity. In this way, high isolation required for radio frequency transmission on the golden finger contact interface can be implemented.

In a possible design, the connector further includes a conductive member, the conductive member includes a first soldering portion, a first bending portion, and a second soldering portion, the first soldering portion is fastened to a first end of the first bending portion, and a second end of the first bending portion is fastened to the second soldering portion; and the first soldering portion is configured to be soldered to the first spring terminal, the soldering portion is configured to be soldered to a third spring terminal, and the first bending portion bypasses the second spring terminal, so that the conductive member is not in contact with the second spring terminal. Based on such a design, ground pins of the spring terminals can be connected to each other, so that cavity isolation can be implemented. In this way, high isolation required for radio frequency transmission on the golden finger contact interface is implemented, and technical effect of reducing near-end crosstalk is achieved.

In a possible design, the connector further includes a second bending portion, a third soldering portion, a third bending portion, and a fourth soldering portion, a first end of the second bending portion is fastened to the second soldering portion, a second end of the second bending portion is fastened to the third soldering portion, the third soldering portion is fastened to a first end of the third bending portion, and a second end of the third bending portion may be fastened to the fourth soldering portion. Based on such a design, ground pins of the spring terminals can be connected to each other, so that cavity isolation can be implemented. In this way, high isolation required for radio frequency transmission on the golden finger contact interface is implemented, and technical effect of reducing near-end crosstalk is achieved.

In a possible design, the second bending portion is configured to bypass a fourth spring terminal and a fifth spring terminal, so that the conductive member is not in contact with the fourth spring terminal and the fifth spring terminal; the third soldering portion is configured to be soldered to a sixth spring terminal; the third bending portion is configured to bypass a seventh spring terminal, so that the conductive member is not contact with the seventh spring terminal; and the fifth soldering portion is configured to be soldered to an eighth spring terminal. Based on such a design, ground pins of the spring terminals can be connected to each other, and the signal receive terminal and the signal transmit terminal in the spring terminals can perform signal transmission with the golden finger module, so that effect of reducing near-end crosstalk can be achieved, and signal transmission quality can be improved.

In a possible design, a first through groove and a second through groove are disposed on the second bending portion, a first metal contact is disposed on a side wall of the first through groove, and a second metal contact is disposed on a side wall of the second through groove. According to this embodiment of this application, the metal contact may be in contact with the isolation member, to provide grounding for the spring terminal, so that the connector can form an electromagnetic shielding cavity.

In a possible design, a first end of the first isolation plate is fastened to a second end of the second isolation plate, a first hook is disposed at a second end of the first isolation plate, and a second hook is disposed at a second end of the second isolation plate; the first hook is configured to pass through the first through groove, and the first metal contact abuts against the isolation plate; and the second hook is configured to pass through the second through groove, and the second metal contact abuts against the second isolation plate. According to this embodiment of this application, two metal contacts are separately in contact with the isolation member, and two isolation plates may be in contact with the two metal contacts, so that two spring terminal modules can be isolated in different chambers. In this way, high isolation required for radio frequency transmission on the golden finger contact interface is implemented.

According to a second aspect, an embodiment of this application further provides a connector assembly. The connector assembly includes a printed circuit board and the foregoing connector, and the connector is fastened on the printed circuit board. According to the connection assembly in this embodiment of this application, an isolation member may be soldered to a ground plane of the printed circuit board, to connect the isolation member to the ground plane of the printed circuit board. In addition, the isolation member may further isolate two spring terminal modules in two different chambers. In this way, high isolation required for radio frequency transmission on a golden finger contact interface can be implemented, and effect of reducing near-end crosstalk can also be achieved.

According to a third aspect, an embodiment of this application further provides a radio frequency module. The radio frequency module includes the foregoing connector assembly. According to the radio frequency module in this embodiment of this application, high isolation required for radio frequency transmission on a golden finger contact interface can be implemented, and effect of reducing near-end crosstalk can be achieved.

According to a fourth aspect, an embodiment of this application further provides a communication device. The communication device includes the foregoing radio frequency module.

According to the connector, the connector assembly, the radio frequency module, and the communication device that are provided in embodiments of this application, high isolation required for radio frequency on a golden finger contact interface can be implemented, and near-end crosstalk can also be reduced, so that a high-density layout is implemented.

### BRIEF DESCRIPTION OF DRAWINGS

FIG. 1 is a schematic diagram of a connection assembly according to an embodiment of this application;
FIG. 2 is a schematic diagram of disassembly of a connection assembly according to an embodiment of this application;
FIG. 3 is a schematic diagram of a structure of a connector according to an embodiment of this application;
FIG. 4 is another schematic diagram of a structure of a connector according to an embodiment of this application;
FIG. 5 is another schematic diagram of a connector according to an embodiment of this application;
FIG. 6 is another schematic diagram of a connector according to an embodiment of this application;
FIG. 7 is a schematic diagram of a structure of a spring terminal according to an embodiment of this application;
FIG. 8 is a schematic diagram of a spring terminal group according to an embodiment of this application;
FIG. 9 is another schematic diagram of a spring terminal group according to an embodiment of this application;
FIG. 10 is a schematic diagram of an isolation member according to an embodiment of this application;
FIG. 11 is another schematic diagram of an isolation member according to an embodiment of this application;
FIG. 12 is another schematic diagram of a connector according to an embodiment of this application;
FIG. 13 is another schematic diagram of a connector according to an embodiment of this application;
FIG. 14 is a schematic diagram of a conductive member according to an embodiment of this application;
FIG. 15 is a schematic diagram of a golden finger contact end according to an embodiment of this application;
FIG. 16 is another schematic diagram of a golden finger contact end according to an embodiment of this application;
FIG. 17 is another schematic diagram of a golden finger contact end according to an embodiment of this application;
FIG. 18 is another schematic diagram of a golden finger contact end according to an embodiment of this application;
FIG. 19 is a cross-sectional view along XIX-XIX in FIG. 1; and
FIG. 20 is a schematic diagram of simulation of a connector according to an embodiment of this application.

Description of reference numerals of main elements:

| | |
|---|---|
| Connector assembly | 100 |
| Golden finger contact end | 300 |
| Connector | 10 |
| Housing | 11 |
| Accommodation cavity | 111 |
| Mounting portions | 112 and 113 |
| Spring terminal groups | 12 and 13 |
| Isolation member | 14 |
| Fastening members | 15, 16, and 17 |
| Conductive member | 18 |
| Printed circuit board | 20 |
| First surface | 21 |
| Second surface | 22 |
| Golden finger modules | 23, 24, 25, and 26 |
| Metal layers | 211, 221, and 272 |
| Insulation layers | 231, 251, and 281 |
| Ground planes | 241 and 261 |
| Accommodation groove | 27 |
| First chamber | 30 |
| Second chamber | 40 |
| Spring terminal modules | 121, 122, 131, and 132 |
| Spring terminals | 123a, 123b, 123c, 123d, 124a, 124b, 124c, 124d, 124e, 133a, 133b, 133c, 133d, 134a, 134b, 134c, 134d, and 134e |
| Soldering portions | 201a, 201b, 201c, 201d, 202a, 202b, 202c, 202d, 202e, 203a, 203b, 203c, 203d, 204a, 204b, 204c, 204d, 204e, 205a, 205b, 181, 183, 185, and 187 |
| Isolation plates | 141 and 142 |

| | |
|---|---|
| Hooks | 143 and 144 |
| Connection portions | 145 and 146 |
| Metal domes | 147 and 148 |
| Slots | 151 and 152 |
| Positioning portion | 153 |
| Bending portions | 182, 184, and 186 |
| Positioning hole | 189 |
| Through grooves | 1841 and 1843 |
| Metal contacts | 1842 and 1844 |
| Ground via | 291 |

The following specific implementations further describe this application in detail with reference to the foregoing accompanying drawings.

### DESCRIPTION OF EMBODIMENTS

It should be noted that, when it is considered as that an element is "connected" to another element, the element may be directly connected to the another element, or there may also be an element disposed between the element and the another element. When it is considered as that an element is "disposed" on another element, the element may be directly disposed on the another element, or there may also be an element disposed between the element and the another element.

Unless otherwise defined, all technical and scientific terms used in this specification have same meanings as those usually understood by a person skilled in the art of this application. The terms used in this specification of this application are merely for the purpose of describing specific embodiments, but are not intended to limit this application. The term " and/or" used in this specification includes any and all combinations of one or more related listed items.

To facilitate understanding of a connector provided in embodiments of this application, the following describes an application scenario of the connector in embodiments of this application. The connector may be used in a communication device, and the connector may be configured to transmit a high-speed differential signal and a large current. It may be understood that the communication device may be a device such as a server, a super computer, a router, a switch, or the like. With continuous improvement of communication technologies, requirements on a data transmission rate and transmission quality are increasingly high, and therefore, crosstalk between signals needs to be further reduced. In view of this, embodiments of this application provide a connector, a connector assembly, a radio frequency module, and a communication device. The connector may shield a signal terminal. In this way, high isolation required for radio frequency transmission on a golden finger contact interface can be implemented, and effect of reducing near-end crosstalk can also be achieved, so that a high-density layout is implemented.

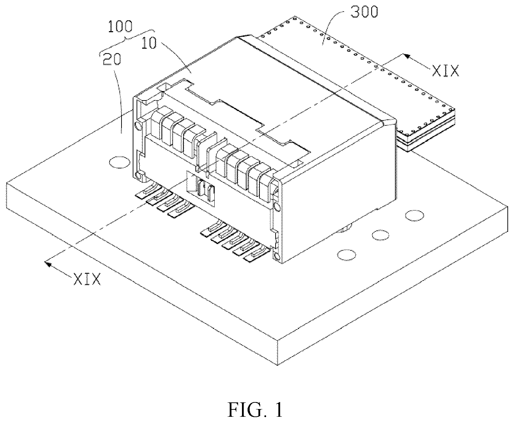

FIG. 1 is a schematic diagram of a structure of a connector assembly 100 according to an embodiment of this application. The connector assembly 100 may include a connector 10 and a printed circuit board 20. The connector 10 may be fastened on the printed circuit board 20. In a possible implementation, the connector 10 may be soldered on the printed circuit board 20.

The connector 10 may be connected to a golden finger contact end 300 through insertion. For example, the golden finger contact end 300 may be inserted into the connector 10, so that signal transmission between the golden finger contact end 300 and the printed circuit board 20 can be implemented.

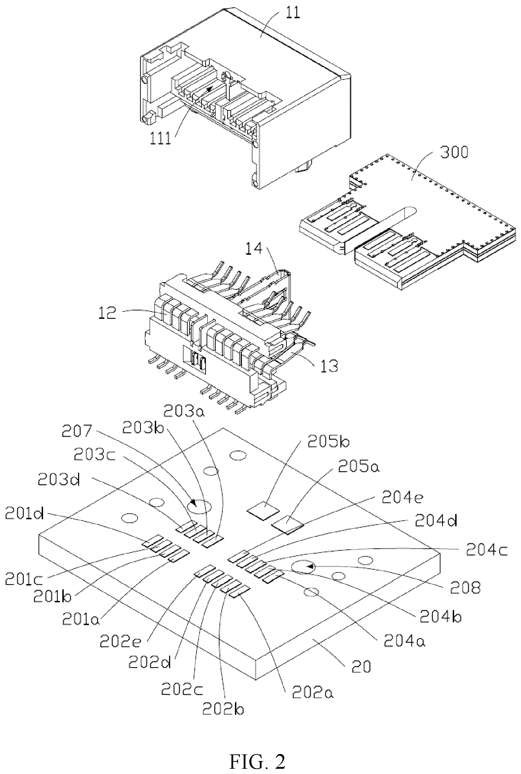

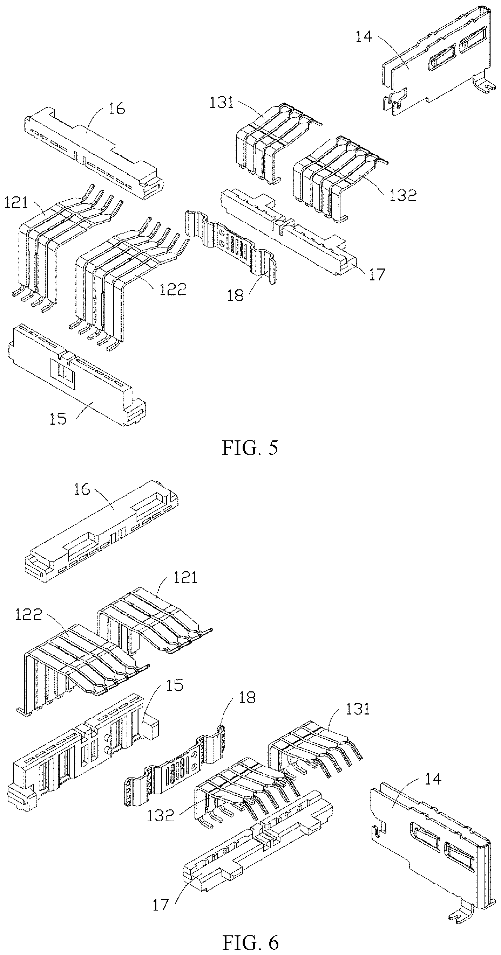

Refer to FIG. 2 to FIG. 6 together. It may be understood that the connector 10 in this embodiment of this application may include a housing 11, a spring terminal group 12, a spring terminal group 13, and an isolation member 14. A terminal accommodation cavity 111 may be formed in the housing 11, and the spring terminal group 12, the spring terminal group 13, and the isolation member 14 may be all disposed in the terminal accommodation cavity 111. It may be understood that the spring terminal group 12 and the spring terminal group 13 in this embodiment of this application may be arranged in a stacking manner.

Optionally, a mounting portion 112 and a mounting portion 113 may be disposed at the bottom of the housing 11, and a mounting hole 207 and a mounting hole 208 may be disposed on the printed circuit board 20. The mounting portion 112 and the mounting portion 113 of the housing may be respectively mounted into the mounting hole 207 and the mounting hole 208 on the printed circuit board 20, so that the housing 11 is fastened on the printed circuit board 20.

In some possible implementations, the spring terminal group 12 may include a spring terminal module 121 and a spring terminal module 122. One end of the spring terminal module 121 and one end of the spring terminal module 122 may be fastened on the printed circuit board 20, and the other end of the spring terminal module 121 and the other end of the spring terminal module 122 may be electrically connected to the golden finger contact end 300. It may be understood that the isolation member 14 may be fastened on the printed circuit board 20.

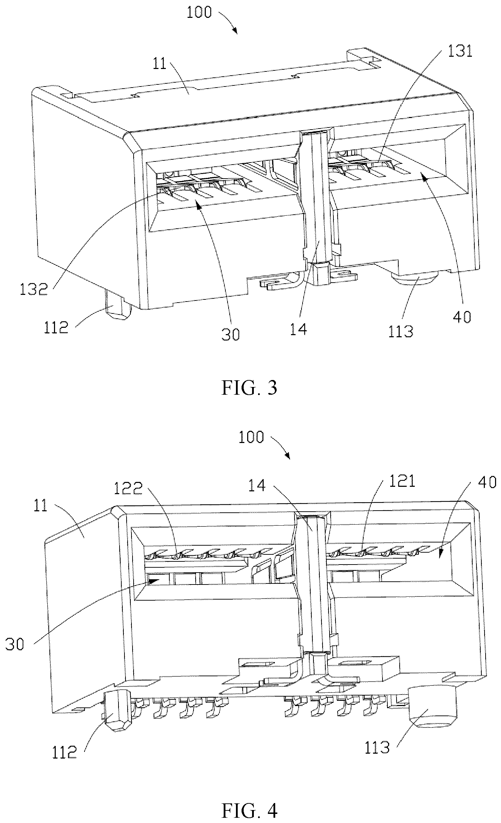

In some possible implementations, the isolation member 14 may be disposed between the spring terminal module 121 and the spring terminal module 122, to isolate the spring terminal module 121 and the spring terminal module 122 in two different chambers. As shown in FIG. 4, the isolation member 14 may isolate the spring terminal module 121 in a first chamber 30, and the isolation member 14 may further isolate the spring terminal module 122 in a second chamber 40.

In some possible implementations, the spring terminal group 13 may include a spring terminal module 131 and a spring terminal module 132. One end of the spring terminal module 131 and one end of the spring terminal module 132 may be fastened on the printed circuit board 20, and the other end of the spring terminal module 131 and the other end of the spring terminal module 132 may be electrically connected to the golden finger contact end 300. It may be understood that the isolation member 14 may be disposed between the spring terminal module 131 and the spring terminal module 132, to isolate the spring terminal module 131 and the spring terminal module 132 in two different chambers. As shown in FIG. 3, the isolation member 14 may isolate the spring terminal module 131 in the first chamber 30, and the isolation member 14 may further isolate the spring terminal module 132 in the second chamber 40.

Based on such a design, the isolation member 14 may isolate the spring terminal module 121 and the spring terminal module 131 in the first chamber 30, and isolate the spring terminal module 122 and the spring terminal module 132 in the second chamber 40.

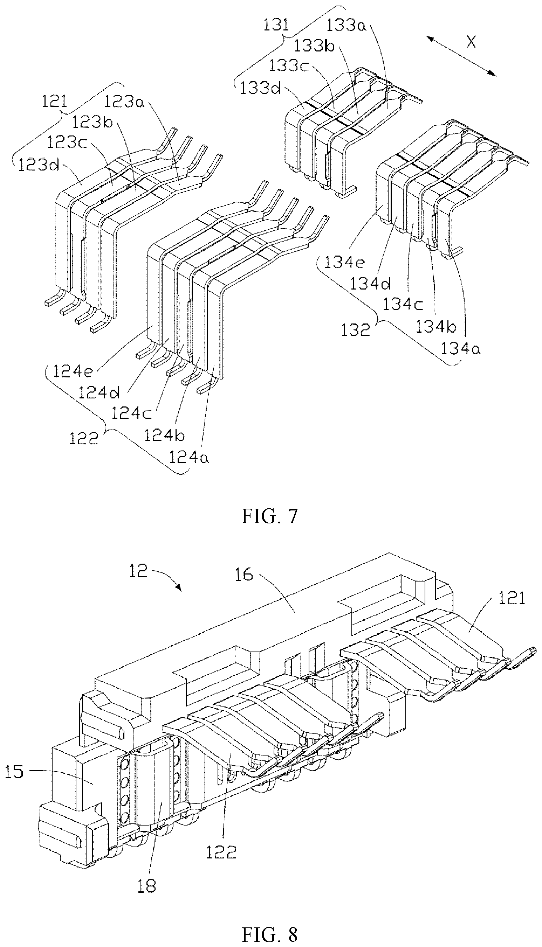

Refer to FIG. 7. In an embodiment, the spring terminal module 121 may include a plurality of spring terminals arranged in a first direction X. The spring terminal module 122 may include a plurality of spring terminals arranged in the first direction X. In this embodiment, an example in which the spring terminal module 121 may include four spring terminals 123a, 123b, 123c, and 123d is used for description, and an example in which the spring terminal module 122 may include five spring terminals 124a, 124b, 124c, 124d, and 124e is used for description.

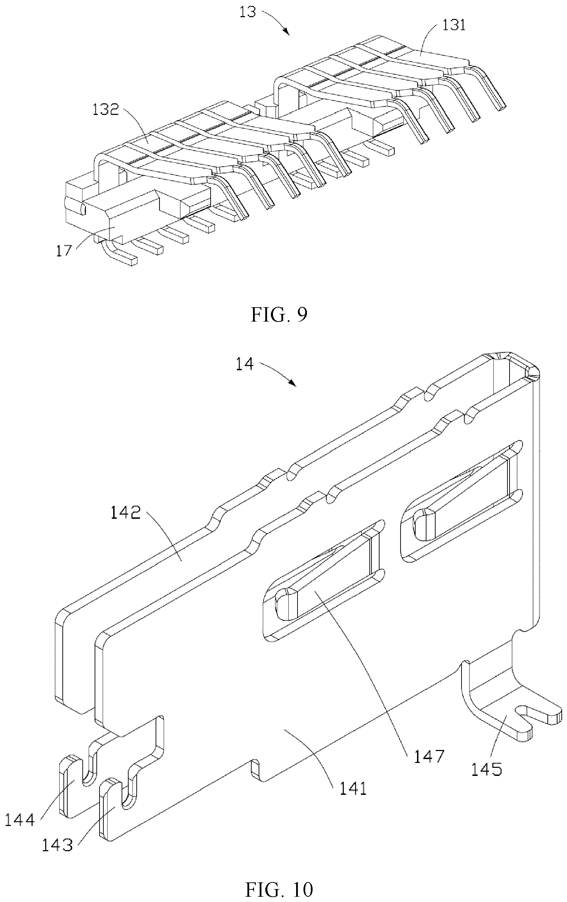

Refer to FIG. 8 and FIG. 9 together. In an embodiment, the spring terminal group 12 may further include a fastening member 15 and a fastening member 16. It may be understood that the fastening member 15 may be configured to be sleeved at a position close to a first end of the spring terminal module 121 and a first end of the spring terminal module 122, and the fastening member 16 may be configured to be sleeved at a position close to a second end of the spring terminal module 121 and a second end of the spring terminal module 122. For example, in an embodiment, the fastening member 15 may be sleeved at a position close to first ends of the spring terminals 123a, 123b, 123c, 123d, 124a, 124b, 124c, 124d, and 124e, and the fastening member 16 may be sleeved at a position close to second ends of the spring terminals 123a, 123b, 123c, 123d, 124a, 124b, 124c, 124d, and 124e. Based on such a design, the fastening member 15 and the fastening member 16 can fasten the spring terminals in the spring terminal module 121 and the spring terminal module 122, so that a case in which these spring terminals are loose or fall off can be avoided.

Optionally, in an embodiment, a plurality of soldering portions may be disposed on the printed circuit board 20, the plurality of soldering portions on the printed circuit board 20 may be soldered to the spring terminals in the spring terminal module 121 and the spring terminal module 122, and the plurality of soldering portions on the printed circuit board 20 may also be soldered to the spring terminals in the spring terminal module 131 and the spring terminal module 132.

For example, in a possible implementation, four soldering portions 201a, 201b, 201c, and 201d may be disposed on the printed circuit board 20. The four soldering portions 201a, 201b, 201c, and 201d on the printed circuit board 20 may correspond to the four spring terminals 123a, 123b, 123c, and 123d in the spring terminal module 121 respectively. Specifically, the first end of the spring terminal 123a may be soldered to the soldering portion 201a, the first end of the spring terminal 123b may be soldered to the soldering portion 201b, the first end of the spring terminal 123c may be soldered to the soldering portion 201c, and the first end of the spring terminal 123d may be soldered to the soldering portion 201d.

Five soldering portions 202a, 202b, 202c, 202d, and 202e may be further disposed on the printed circuit board 20. The five soldering portions 202a, 202b, 202c, 202d, and 202e on the printed circuit board 20 may correspond to the five spring terminals 124a, 124b, 124c, 124d, and 124e in the spring terminal module 122 respectively. Specifically, the first end of the spring terminal 124a may be soldered to the soldering portion 202a, the first end of the spring terminal 124b may be soldered to the soldering portion 202b, the first end of the spring terminal 124c may be soldered to the soldering portion 202c, the first end of the spring terminal 124d may be soldered to the soldering portion 202d, and the first end of the spring terminal 124e may be soldered to the soldering portion 202e.

In an embodiment, the spring terminal module 131 may include a plurality of spring terminals arranged in a first direction X. The spring terminal module 132 may include a plurality of spring terminals arranged in the first direction X. In this embodiment, an example in which the spring terminal module 131 includes four spring terminals 133a, 133b, 133c, and 133d is used for description, and an example in which the spring terminal module 132 includes five spring terminals 134a, 134b, 134c, 134d, and 134e is used for description.

In an embodiment, the spring terminal group 13 may further include a fastening member 17. It may be understood that the fastening member 17 may be configured to be sleeved at a position close to a first end of the spring terminal module 131 and a first end of the spring terminal module 132. For example, in an embodiment, the fastening member 17 may be sleeved at a position close to first ends of the spring terminals 133a, 133b, 133c, 133d, 134a, 134b, 134c, 134d, and 134e. Based on such a design, the fastening member 17 can fasten the spring terminals in the spring terminal module 131 and the spring terminal module 132, so that a case in which these spring terminals are loose or fall off can be avoided.

Based on the design in the foregoing embodiment, ground pins of the spring terminal group 12 and the spring terminal group 13 may be electrically connected to each other through the isolation member 14.

For example, in a possible implementation, four soldering portions 203a, 203b, 203c, and 203d may be further disposed on the printed circuit board 20. The four soldering portions 203a, 203b, 203c, and 203d on the printed circuit board 20 may correspond to the four spring terminals 133a, 133b, 133c, and 133d in the spring terminal module 131 respectively. Specifically, the first end of the spring terminal 133a may be soldered to the soldering portion 203a, the first end of the spring terminal 133b may be soldered to the soldering portion 203b, the first end of the spring terminal 133c may be soldered to the soldering portion 203c, and the first end of the spring terminal 133d may be soldered to the soldering portion 203d.

In a possible implementation, five soldering portions 204a, 204b, 204c, 204d, and 204e may be further disposed on the printed circuit board 20. The five soldering portions 204a, 204b, 204c, 204d, and 204e on the printed circuit board 20 may correspond to the five spring terminals 134a, 134b, 134c, 134d, and 134e in the spring terminal module 132 respectively. Specifically, the first end of the spring terminal 134a may be soldered to the soldering portion 204a, the first end of the spring terminal 124b may be soldered to the soldering portion 204b, the first end of the spring terminal 134c may be soldered to the soldering portion 204c, the first end of the spring terminal 134d may be soldered to the soldering portion 204d, and the first end of the spring terminal 134e may be soldered to the soldering portion 204e.

Function definitions of the spring terminals of the connector 10 are shown in the following Table 1.

**Table 1: Function definitions of the spring terminals**

| | | | | | | | | | |
|---|---|---|---|---|---|---|---|---|---|
| Spring terminal group 12 | Spring terminal 124a | Spring terminal 124b | Spring terminal 124c | Spring terminal 124d | Spring terminal 124e | Spring terminal 123a | Spring terminal 123b | Spring terminal 123c | Spring terminal 123d |
| | POWER | GND | RX1 | GND | LS | LS | GND | TX1 | GND |
| Spring terminal group 13 | Spring terminal 134a | Spring terminal 134b | Spring terminal 134c | Spring terminal 134d | Spring terminal 134e | Spring terminal 133a | Spring terminal 133b | Spring terminal 133c | Spring terminal 133d |
| | GND | RX2 | GND | LS | GND | GND | TX2 | GND | POWER |

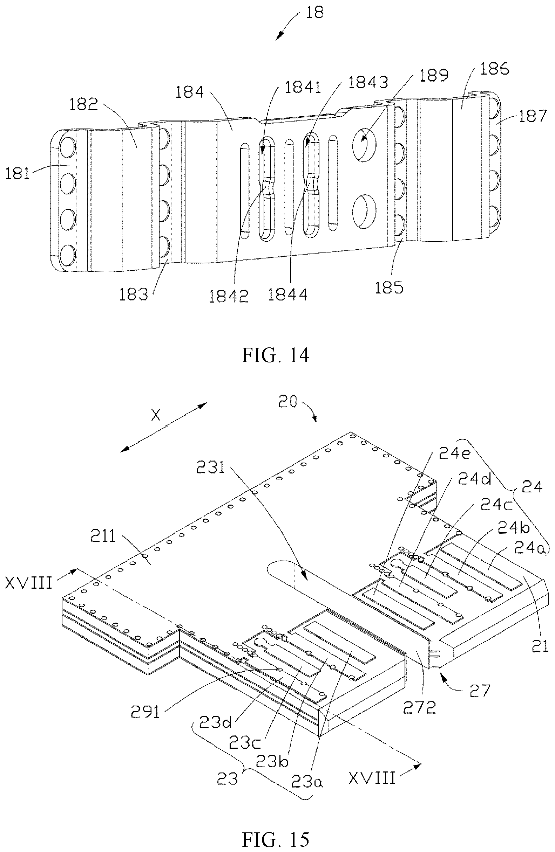

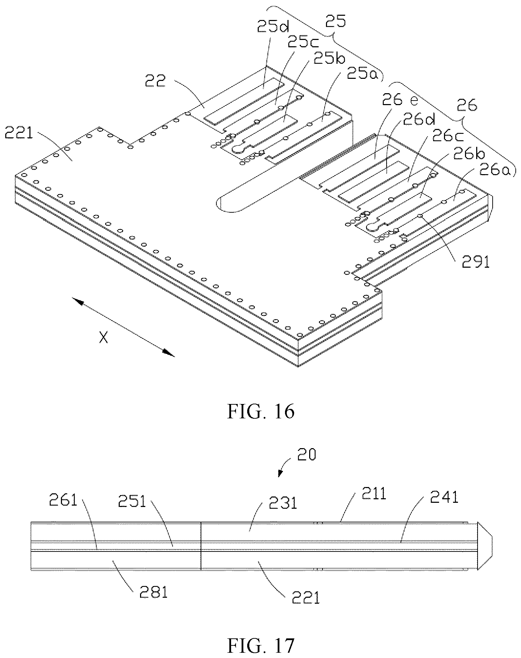

Refer to FIG. 15 and FIG. 16 together. In a possible implementation, the golden finger contact end 300 may include a first surface 21 and a second surface 22 that is disposed opposite to the first surface 21.

A golden finger module 23 and a golden finger module 24 are disposed on the first surface 21. A golden finger module 25 and a golden finger module 26 are disposed on the second surface 22. The golden finger module 23 may include a plurality of golden fingers arranged along the first direction X. The golden finger module 24 may include a plurality of golden fingers arranged along the first direction X. The golden finger module 25 may include a plurality of golden fingers arranged along the first direction X. The golden finger module 26 may include a plurality of golden fingers arranged along the first direction X. For example, the golden finger module 23 may include golden fingers 23a, 23b, 23c, and 23d. The golden finger module 24 may include golden fingers 24a, 24b, 24c, 24d, and 24e. The golden finger module 25 may include golden fingers 25a, 25b, 25c, and 25d. The golden finger module 26 may include golden fingers 26a, 26b, 26c, 26d, and 26e.

It may be understood that, in this embodiment, when the golden finger contact end 300 is inserted into the connector 10, the golden fingers on the golden finger contact end 300 may be in contact with the spring terminals of the spring terminal group 12 and the spring terminal group 13, so that a signal can be transferred.

For example, if the golden finger contact end 300 is inserted into the connector 10, the second end of the spring terminal 123a may abut against the golden finger 23a, the second end of the spring terminal 123b may abut against the golden finger 23b, the second end of the spring terminal 123c may abut against the golden finger 23c, and the second end of the spring terminal 123d may abut against the golden finger 23d; the second end of the spring terminal 124a may abut against the golden finger 24a, the second end of the spring terminal 124b may abut against the golden finger 24b, the second end of the spring terminal 124c may abut against the golden finger 24c, the second end of the spring terminal 124d may abut against the golden finger 24d, and the second end of the spring terminal 124e may abut against the golden finger 24e; a second end of the spring terminal 133a may abut against the golden finger 25a, a second end of the spring terminal 133b may abut against the golden finger 25b, a second end of the spring terminal 133c may abut against the golden finger 25c, and a second end of the spring terminal 133d may abut against the golden finger 25d; and a second end of the spring terminal 134a may abut against the golden finger 26a, a second end of the spring terminal 124b may abut against the golden finger 26b, a second end of the spring terminal 134c may abut against the golden finger 26c, a second end of the spring terminal 134d may abut against the golden finger 26d, and a second end of the spring terminal 134e may abut against the golden finger 26e.

In a possible implementation, an accommodation groove 27 may be disposed at the golden finger contact end 300, and the accommodation groove 27 may be located between the golden finger module 23 and the golden finger module 24. In an embodiment, the accommodation groove 27 may be a U-shaped groove. Based on such a design, when the golden finger contact end 300 abuts against the connector 10, at least a part of the isolation member 14 may be accommodated in the accommodation groove 27.

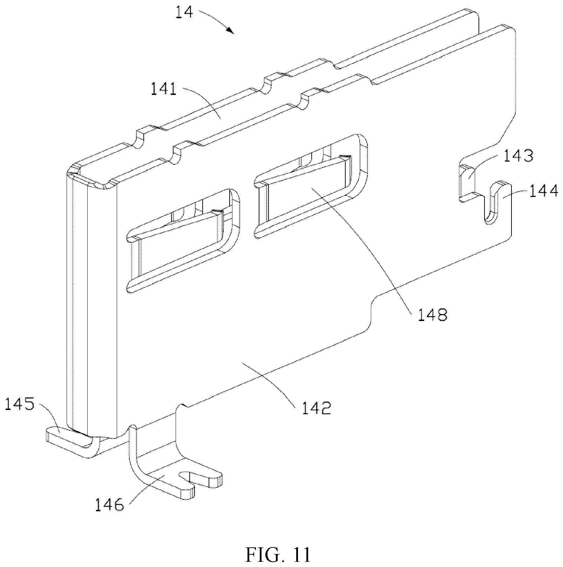

Refer to FIG. 10 and FIG. 11 together. The isolation member 14 may include an isolation plate 141 and an isolation plate 142. It may be understood that, in an embodiment, the isolation member 14 may be made of a metal material.

A first end of the isolation plate 141 is fastened to a second end of the isolation plate 142. A hook 143 is disposed at a second end of the isolation plate 141, and a hook 144 is disposed at the second end of the isolation plate 142.

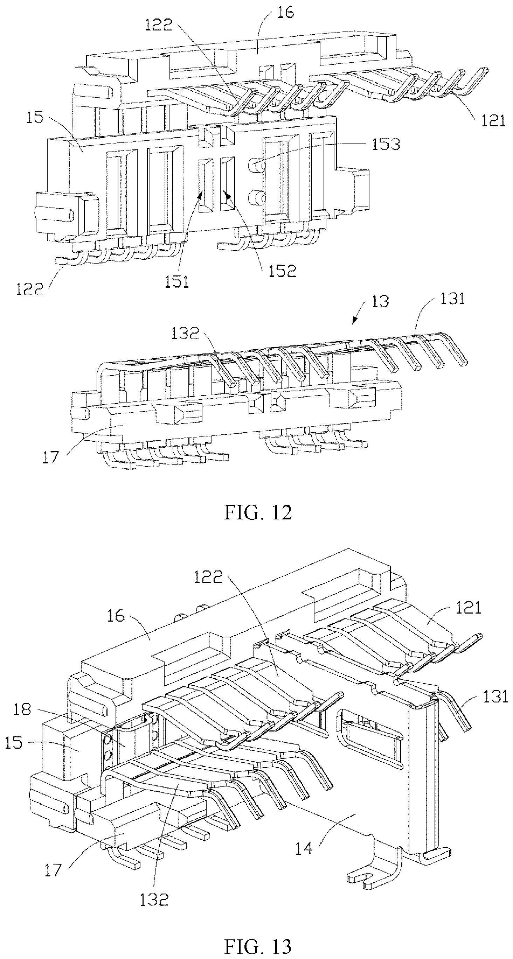

Further, refer to FIG. 12 to FIG. 14. The connector 10 may further include a conductive member 18. It may be understood that, in an embodiment, the conductive member 18 may be made of a metal material. The conductive member 18 includes a soldering portion 181, a bending portion 182, and a soldering portion 183. The soldering portion 181 is fastened to a first end of the bending portion 182, and a second end of the bending portion 182 is fastened to the soldering portion 183. The soldering portion 181 may be configured to be soldered to the spring terminal 124b, the soldering portion 183 may be configured to be soldered to the spring terminal 124d, and the bending portion 182 may bypass the spring terminal 124c, so that the conductive member 18 may be not in contact with the spring terminal 124c.

Optionally, the connector 10 may further include a bending portion 184, a soldering portion 185, a bending portion 186, and a soldering portion 187. A first end of the bending portion 184 may be fastened to the soldering portion 183, a second end of the bending portion 184 may be fastened to the soldering portion 185, the soldering portion 185 may be further fastened to a first end of the bending portion 186, and a second end of the bending portion 186 may be fastened to the soldering portion 187.

The bending portion 184 may be configured to bypass the spring terminal 124e and the spring terminal 123a, so that the conductive member 18 is not in contact with the spring terminal 124e and the spring terminal 123a.

The soldering portion 185 is configured to be soldered to the spring terminal 123b, and the bending portion 186 may be configured to bypass the spring terminal 123c, so that the conductive member 18 is not in contact with the spring terminal 123c. The soldering portion 187 may be configured to be soldered to the spring terminal 123d.

In an embodiment, a through groove 1841 and a through groove 1843 may be disposed on the bending portion 184. Optionally, a metal contact 1842 may be disposed on a side wall of the through groove 1841, and a metal contact 1844 may be disposed on a side wall of the through groove 1843. A slot 151 and a slot 152 may be disposed on the fastening member 15.

Based on such a design, the hook 143 may pass through the through groove 1841 and be stuck into the slot 151, and when the hook 143 passes through the through groove 1841, the metal contact 1842 may abut against the isolation plate 141. The hook 144 may pass through the through groove 1843 and be stuck into the slot 152, and when the hook 144 passes through the through groove 1843, the metal contact 1844 may abut against the isolation plate 142. In this way, the isolation member 14 may provide grounding for the conductive member 18, and further provide grounding for the spring terminal 124b, the spring terminal 124d, the spring terminal 123b, and the spring terminal 123d.

In an embodiment, a positioning hole 189 may be further disposed on the bending portion 184, and a positioning portion 153 that is connected to the positioning hole 189 may be disposed on the fastening member 15. The positioning portion 153 may fit the positioning hole 189, to position the conductive member 18.

A connection portion 145 is disposed at the bottom of the isolation plate 141, and a connection portion 146 is disposed at the bottom of the isolation plate 142. It may be understood that, in some possible implementations, a soldering portion 205a and a soldering portion 205b may be further disposed on the printed circuit board 20. The connection portion 145 and the connection portion 146 may correspond to the soldering portion 205a and the soldering portion 205b respectively. To be specific, the connection portion 145 may be soldered to the soldering portion 205a, and the connection portion 146 may be soldered to the soldering portion 205b. Based on such a design, the isolation member 14 may be fastened on the printed circuit board 20.

Further, the printed circuit board 20 may provide grounding for the isolation member 14. Specifically, the connection portion 145 of the isolation member 14 may be connected to a ground plane (not shown in the figure) of the printed circuit board 20 through the soldering portion 205a, and the connection portion 146 of the isolation member 14 may be connected to the ground plane of the printed circuit board 20 through the soldering portion 205b.

In some possible implementations, a metal dome 147 may be disposed on the isolation plate 141, and a metal dome 148 is disposed on the isolation plate 142. It may be understood that the metal dome 147 may be connected to the ground plane of the printed circuit board 20, and the metal dome 148 may be connected to the ground plane of the printed circuit board 20.

In an embodiment, a metal layer 272 is disposed on each of two side walls of the accommodation groove 27. In a possible implementation, the metal layer 271 is grounded. For example, when the golden finger contact end 300 is inserted into the connector 10, at least a part of the isolation member 14 may be accommodated in the accommodation groove 27. The metal dome 147 of the isolation plate 141 and the metal dome 148 of the isolation plate 142 may abut against the two side walls of the accommodation groove 27 respectively. To be specific, the metal dome 147 and the metal dome 148 may abut against the metal layers 272 on the two side walls of the accommodation groove 27.

It may be understood that, in some embodiments, a metal layer 211 may be disposed on the first surface 21 of the golden finger contact end 300, and the metal layer 211 on the first surface 21 may be connected to the metal layers 272 in the accommodation groove 27. Specifically, the golden finger 23a and the golden finger 23c are both electrically connected to the metal layer 211, and the golden finger 24a, the golden finger 24c, and the golden finger 24e are all electrically connected to the metal layer 211.

Further, a metal layer 221 may be disposed on the second surface 22 of the golden finger contact end 300, and the metal layer 221 on the second surface 22 may be connected to the metal layers 272 in the accommodation groove 27. Specifically, the golden finger 25a and the golden finger 25c are both electrically connected to the metal layer 221, and the golden finger 26a, the golden finger 26c, and the golden finger 26e are all electrically connected to the metal layer 221.

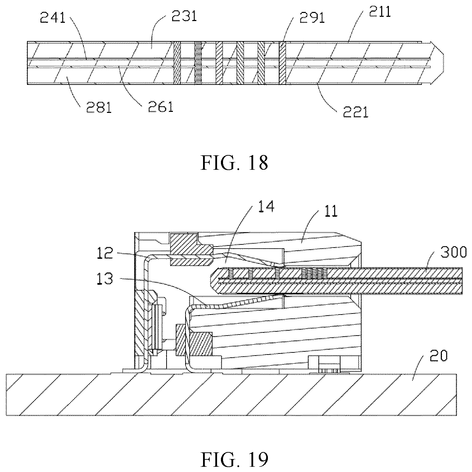

Refer to FIG. 17 and FIG. 18 together. In this embodiment, the golden finger contact end 300 may include the metal layer 211, an insulation layer 231, a ground plane 241, an insulation layer 251, a ground plane 261, an insulation layer 281, and the metal layer 221 that are sequentially arranged.

A ground via 291 is opened on the periphery of each of the golden finger 23a, the golden finger 23c, the golden finger 24a, the golden finger 24c, and the golden finger 24e, and the ground via 291 may communicate with the ground plane 241. A ground via 291 is opened on the periphery of each of the golden finger 25a, the golden finger 25c, the golden finger 26a, the golden finger 26c, and the golden finger 26e, and the ground via 291 may communicate with the ground plane 261.

As shown in FIG. 19, when the golden finger contact end 300 is inserted into the connector 10, the golden fingers on the golden finger contact end 300 abut against the spring terminals of the connector 10. It may be understood that the connector 10 in this embodiment of this application may include up and down two rows of spring terminals. Ground pins of the spring terminals may be connected to each other through the isolation member 14. The isolation member 14 is disposed between the spring terminal module 121 and the spring terminal module 122, and the isolation member 14 is connected to the ground plane of the printed circuit board 20.

In a process of mating, the metal dome 147 and the metal dome 148 of the isolation member 14 may be directly in contact with ground pins of mating golden fingers, so that one component may be isolated into two cavities, to adapt to a layout of TX and RX signals. This implements a high-density and high-isolation solution.

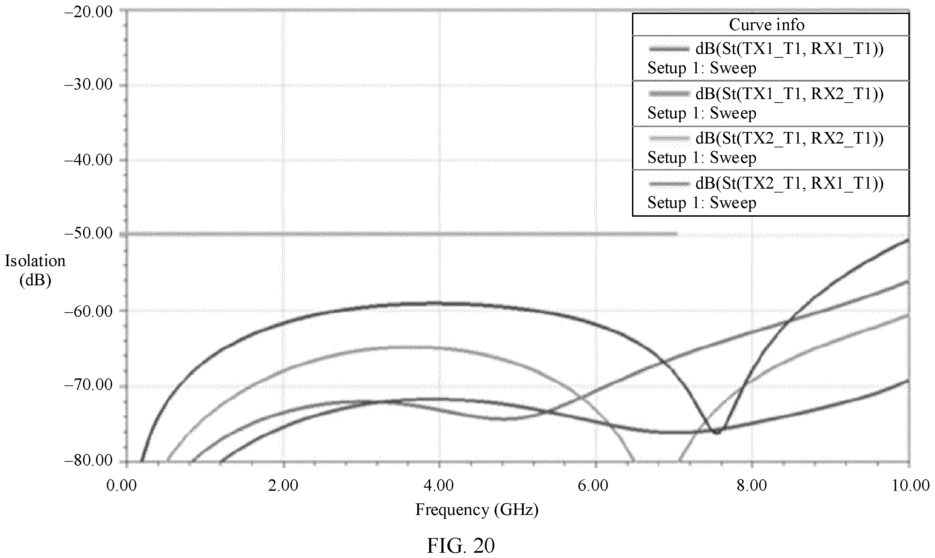

FIG. 20 is a diagram of simulation effect of a connector 10 according to an embodiment of this application. It can be learned that the connector 10 provided in this embodiment of this application can meet a signal isolation requirement.

An embodiment of this application further provides a radio frequency module. The radio frequency module may include the connector assembly 100 described in the foregoing embodiment. It may be understood that an embodiment of this application further provides a communication device. The communication device may include the radio frequency module described in the foregoing embodiment.

According to the connector, the connector assembly, the radio frequency module, and the communication device that are provided in embodiments of this application, high isolation required for radio frequency transmission on a golden finger contact interface can be implemented, and effect of reducing near-end crosstalk can also be achieved, so that a high-density layout is implemented.

The foregoing descriptions are merely example implementations of this application, but are not intended to limit this application in any form. Although this application has been disclosed as example implementations as described above, the embodiments are not intended to limit this application. Any person skilled in the art may make some variations or medications to the foregoing disclosed technical content as equivalent implementations with equivalent variations without departing from the scope of the technical solutions of this application. Any simple change, equivalent variation, and modification made to the foregoing implementations based on the technical essence of this application without departing from the content of the technical solutions of this application shall fall within the scope of the technical solutions of this application.

## Claims

1. A connector, fastened on a printed circuit board, wherein the connector comprises a first spring terminal module, a second spring terminal module, an isolation member, and a golden finger contact end, wherein
the golden finger contact end comprises a first golden finger module and a second golden finger module;
the first spring terminal module comprises a plurality of first spring terminals, the plurality of first spring terminals each comprise a signal transmit terminal, first ends of the plurality of first spring terminals are soldered to a ground plane of the printed circuit board, and second ends of the plurality of first spring terminals abut against the first golden finger module;
the second spring terminal module comprises a plurality of second spring terminals, the plurality of second spring terminals each comprise a signal receive terminal, first ends of the plurality of second spring terminals are soldered to the ground plane of the printed circuit board, and second ends of the plurality of second spring terminals abut against the second golden finger module; and
the isolation member is soldered to the ground plane of the printed circuit board, and the isolation member is disposed between the first spring terminal module and the second spring terminal module, to isolate the first spring terminal module and the second spring terminal module in different chambers.

2. The connector according to claim 1, wherein
an accommodation groove is disposed at the golden finger contact end, and the accommodation groove is located between the first golden finger module and the second golden finger module; and when the golden finger contact end abuts against the plurality of first spring terminals and the plurality of second spring terminals, at least a part of the isolation member is accommodated in the accommodation groove.

3. The connector according to claim 2, wherein
the isolation member comprises a first isolation plate, a first metal dome is disposed on the first isolation plate, and a first metal layer is disposed on an inner wall of the accommodation groove; and when at least the part of the isolation member is accommodated in the accommodation groove, the first metal dome abuts against the first metal layer, to provide grounding for the golden finger contact end.

4. The connector according to claim 2, wherein
the isolation member comprises a second isolation plate, and a second metal dome is disposed on the second isolation plate; and when at least the part of the isolation member is accommodated in the accommodation groove, the second metal dome abuts against the first metal layer, to provide grounding for the golden finger contact end.

5. The connector according to claim 1, wherein
the connector further comprises a conductive member, the conductive member comprises a first soldering portion, a first bending portion, and a second soldering portion, the first soldering portion is fastened to a first end of the first bending portion, and a second end of the first bending portion is fastened to the second soldering portion; and the first soldering portion is configured to be soldered to the first spring terminal, the soldering portion is configured to be soldered to a third spring terminal, and the first bending portion bypasses the second spring terminal, so that the conductive member is not in contact with the second spring terminal.

6. The connector according to claim 5, wherein
the connector further comprises a second bending portion, a third soldering portion, a third bending portion, and a fourth soldering portion, a first end of the second bending portion is fastened to the second soldering portion, a second end of the second bending portion is fastened to the third soldering portion, the third soldering portion is fastened to a first end of the third bending portion, and a second end of the third bending portion may be fastened to the fourth soldering portion.

7. The connector according to claim 6, wherein
the second bending portion is configured to bypass a fourth spring terminal and a fifth spring terminal, so that the conductive member is not in contact with the fourth spring terminal and the fifth spring terminal; the third soldering portion is configured to be soldered to a sixth spring terminal; the third bending portion is configured to bypass a seventh spring terminal, so that the conductive member is not contact with the seventh spring terminal; and the fifth soldering portion is configured to be soldered to an eighth spring terminal.

8. The connector according to claim 7, wherein
a first through groove and a second through groove are disposed on the second bending portion, a first metal contact is disposed on a side wall of the first through groove, and a second metal contact is disposed on a side wall of the second through groove.

9. The connector according to claim 8, wherein
a first end of the first isolation plate is fastened to a second end of the second isolation plate, a first hook is disposed at a second end of the first isolation plate, and a second hook is disposed at a second end of the second isolation plate; the first hook is configured to pass through the first through groove, and the first metal contact abuts against the isolation plate; and the second hook is configured to pass through the second through groove, and the second metal contact abuts against the second isolation plate.

10. A connector assembly, wherein the connector assembly comprises a printed circuit board and the connector according to any one of claims 1 to 9, and the connector is fastened on the printed circuit board.

11. A radio frequency module, wherein the radio frequency module comprises the connector assembly according to claim 10.

12. A communication device, wherein the communication device comprises the radio frequency module according to claim 11.
